# EUROPÄISCHE PATENTANMELDUNG

(11) **EP 1 977 991 A2**
(43) Veröffentlichungstag der Anmeldung: **08.10.2008**
(21) Anmeldenummer: 08154171.6
(22) Anmeldetag: 07.04.2008
(51) Int. Cl.: B81C 1/00

(54) **Mikrostrukturierte Bauteile mit einem Substrat und einem an das Substrat direkt ankontaktierten Chip, sowie Verfahren zu deren Herstellung**

(30) Priorität: 05.04.2007 DE 102007016608; 05.10.2007 DE 102007047771
(71) Anmelder: Fraunhofer-Gesellschaft zur Förderung der angewandten Forschung e.V., 80686 München (DE)
(72) Erfinder: Reinert, Wolfgang, 24536, Neumünster (DE); Marenco, Norman, 25582, Hohenaspe (DE)
(74) Vertreter: Leonhard, Frank Reimund

(57) **Zusammenfassung**

Die vorliegende Erfindung betrifft ein mikrostrukturiertes Bauteil für Mikrosensoren oder andere aktive Mikrobauelemente, umfassend ein Substrat (1) sowie mindestens einen Chip (2), die auf ihren einander zugewandten Oberflächen jeweils eine oder mehrere aktive Strukturen (5) tragen, wobei das Substrat und der mindestens eine Chip über einen Versiegelungsrahmen (3) so miteinander verbunden sind, dass die jeweils mindestens eine aktive Struktur auf dem Chip und auf dem Substrat gegenüber unerwünschten Umwelteinflüssen ausreichend geschützt ist/sind. Der mindestens eine Chip trägt auf seiner dem Substrat zugewandten Oberfläche mindestens eine elektrische Kontaktstelle (4), die mit einer oder der/den aktiven Struktur(en) (5) in leitendem Kontakt steht, wobei die oder mindestens eine der genannten elektrischen Kontaktstellen (4) eines jeden der genannten Chips mit einer auf dem Substrat befindlichen, elektrischen Kontaktstelle (4') elektrisch leitend verbunden ist, die ihrerseits mit einer Leiterstruktur auf dem oder innerhalb des Substrats verbunden ist, welche sich auf dem Substrat außerhalb der von dem oder den Chips besetzten Arealen ankontaktieren lässt. Dadurch wird es möglich, dass die elektrischen Verbindung zwischen der/den aktiven Strukturen (5) und dem Substrat ausschließlich über die genannten Kontaktstellen (4, 4') erfolgt. Die Erfindung betrifft außerdem ein Verfahren, mit dessen Hilfe das mikrostrukturierte Bauteil erhältlich ist.

## Beschreibung

Die vorliegende Erfindung ist auf die Herstellung von mikrostrukturierten Bauteilen (großenteils in Form von Subsystemen) gerichtet, die sich für die Erzeugung von Mikrobauelementen wie Mikrosensoren (Drucksensoren, Inertialsensoren, MEMS und dgl.), Mikrofonen oder optischen Detektoren eignen. Diese Bauteile bzw. Subsysteme umfassen ein Substrat, beispielsweise einen Siliziumwafer mit Auswerteschaltung (ASIC), das häufig später in mehrere Substrate für mehrere solcher Mikrobauelemente unterteilt werden soll, sowie mindestens einen, in der Regel mehrere, aktive Strukturen tragende Chips, die kopfüber, mit den aktiven Strukturen nach unten, auf das Substrat aufgebracht und mit diesem mechanisch und elektrisch/elektronisch verbunden sind. Diese Chips können ihrerseits Bestandteile z.B. eines einzigen Chipwafers sein. Insbesondere betrifft die Erfindung derartige Bauteile bzw. Subsysteme, bei denen sowohl die Oberfläche des Substrats als auch die Oberfläche des Chips (ohne Leiterstrukturen und ohne aktive Strukturen gesehen) eben oder im Wesentlichen eben ist.

Die heutigen mikrosystemtechnischen Bauelemente werden vorzugsweise mit Herstellungsverfahren der Halbleitertechnik gefertigt. Dadurch können kostengünstig viele Bauelemente gleichzeitig hergestellt werden. Diese Bauteile sind jedoch, bedingt durch ihre sehr kleinen Abmessungen, äußerst empfindlich und müssen während des Betriebs bzw. auch schon während der Fertigung gegen äußere Einflüsse geschützt werden. Dies wird bewerkstelligt, indem diese Bauteile durch Schutzkappen hermetisch verschlossen werden.

Verkappungsverfahren sind schon länger bekannt. Oft angewendet wird dabei, dass separate Deckelchips (Deckelwafer) auf den die aktiven Strukturen enthaltenden Wafer aufgeklebt oder durch andere Fügeverfahren aufgebracht werden und so die Elemente hermetisch verschlossen werden. Ebenfalls schon länger bekannt sind Verfahren, die einen MST-Wafer (**M**ikro**S**ystem**T**echnik-Wafer) auf Waferebene verkapseln. Dabei wird ein Wafer, der beispielsweise aus Glas oder Silizium bestehen kann und in der Regel eine oder mehrere Kavitäten zur Aufnahme der aktiven Bauelement-Teile enthält, mittels einer anodischen Verbindung oder durch Einsatz von Glasloten verbunden. Weniger verbreitet in der Waferverbindungstechnik ist der Einsatz von metallischen oder metallhaltigen Loten.

Aus dem Artikel "Advanced-Chip-to Wafer Technology: Enabling Technology for Volume Production of 3D System Integration on Wafer Level" von C. Scheiring et al. in IMAPS 2004, Long Beach, USA lässt sich entnehmen, dass es in manchen Fällen günstiger sein kann, Chips einzeln auf Wafern zu platzieren. Mit dieser Technologie wird das Verkappungsverfahren in zwei Einzelverfahren aufgeteilt: Der Chip wird zuerst in die passende Stellung gegenüber dem Substrat gebracht und vorläufig angeklebt. Erst wenn die korrekte Position sichergestellt ist, erfolgt die endgültige, elektrische und mechanische Verbindung zwischen den Teilen. Hierfür wird die Bildung einer hochschmelzenden Legierung aus niedriger schmelzenden Ausgangsmaterialien vorgeschlagen, beispielsweise Cu3Sn. Die Verbindung erfolgt bei einer Temperatur, die zwischen den Schmelzpunkten der beiden Legierungsmetalle liegt, so dass durch Diffusion des höher schmelzenden Metalls in die Schmelze des niedriger schmelzenden Metalls die noch wesentlich höher schmelzende Legierung als Verbindung gebildet wird.

Diese Technik wird ganz allgemein auch für "MEMS Packaging" vorgeschlagen, weil damit dichtende Verbindungen geschaffen werden könnten, wie sie ja z.B. für im Vakuum oder unter bestimmten Gasen/Gasdrücken arbeitende Mikrosensoren notwendig sein können und weil die Komponenten nicht notwendigerweise die gleiche Größe aufweisen müssen. Für die Verpackung eines Mikrosensors oder einer anderen aktiven Struktur findet sich jedoch kein Beispiel. Aus dem Artikel kann ein Fachmann daher keine Informationen dahingehend entnehmen, wie bei einer solchen Anordnung die elektrischen Verbindungen zwischen den Komponenten verlaufen könnten.

Die Aufbau- und Verbindungstechnik für mikrosensorische und andere aktive Mikrobauelemente muss sich unter anderem mit den folgenden Problemen beschäftigen: Zwischen den Sensorelementen und einer elektronischen Auswerteschaltung (die z.B. Schaltkreise zur Ansteuerung des bzw. der Sensorelemente, zur Messung von deren Signalen und zur Kommunikation mit externen elektrischen Schaltkreisen aufweist) müssen elektrische Verbindungen geschaffen werden. Weiterhin müssen die häufig extrem empfindlichen mikrosensorischen Bauteile und/oder die Halbleiterschaltung vor schädlichen Umgebungseinflüssen wie übermäßiger mechanischer Belastung, störender elektromagnetischer Strahlung und unerwünschten Partikeln geschützt werden. Auch der Schutz vor Flüssigkeiten, Gasen oder Elementarteilchen kann erforderlich sein. Schließlich muss das aktive System, also das aktive Bauteil wie Sensor/Aktuator oder eine Kombination von solchen Bauteilen, in ein Zielsystem integriert werden, z.B. eine Leiterplatte, ein Gehäuse oder eine Oberfläche, die Umgebungseinflüssen ausgesetzt ist. Umgebungseinflüsse können sowohl störender Art sein (z.B. die oben beschriebenen Einflüsse oder aber ein ungeeigneter Gasdruck, eine unerwünschte Gaszusammensetzung), weshalb sie abzuhalten sind, oder sie können nützlich sein (z.B. eine zu detektierende Bewegungsänderung oder Temperatur), weshalb letztere ungestört im Innern des Bauelements feststellbar sein sollen. Anstelle einer direkten Sensorkopplung zwischen Messgröße und Detektionseinheit kann auch ein geeignetes Medium (z.B. Flüssigkeit oder eine optische Linse) die für das sensorische System relevante Messgröße an den Sensor heranführen. Die Integration wird z.B. erleichtert, indem der Bauraum, die Bauhöhe oder die benötigte Grundfläche verkleinert werden.

Ein weiteres Problem liegt im fertigungstechnischen Bereich: Boden- und Deckelteil der Bauelemente müssen sauber zueinander justierbar sein.

Aus wirtschaftlichen und/oder fertigungstechnischen Gründen ist es sinnvoll, einen Aufbau derart zu gestalten, dass die vorgenannten Aspekte mit möglichst geringem Aufwand, d.h. mit nur wenigen Fertigungsschritten und geringem Material- und Energieeinsatz erreicht werden können. Insbesondere mikroelektronische Fertigungstechnologien sind hierfür optimal geeignet, da eine Vielzahl von hochskalig integrierten Bauelementen gleichzeitig und größtenteils automatisiert prozessiert wird.

Aufgabe der vorliegenden Erfindung ist es, ein kompaktes mikrostrukturiertes Bauteil oder Subsystem bereitzustellen, das gehäuste, aktive Mikrostrukturen wie Mikrosensoren (z.B. Inertialsensoren für Geschwindigkeit, Beschleunigung, Drehung, oder Sensoren für Feuchtigkeit, Licht, Temperatur, Radioaktivität oder dergleichen) und/oder Mikroaktuatoren u.ä. enthält und ein Mikrobauelement darstellt oder sich zu solchen Bauelementen vereinzeln lässt, wobei die Struktur des Aufbaus dieses Bauteils oder Subsystems dazu beiträgt, den Gesamtaufwand für die Herstellung der Mikrobauelemente zu verringern, indem es sich mit einfacheren Maßnahmen als bisher für vergleichbare Strukturen erforderlich herstellen lässt.

Diese Aufgabe wird durch die Bereitstellung eines mikrostrukturierten Bauteils für Mikrosensoren oder andere aktive Mikrobauelemente gelöst, umfassend ein Substrat sowie mindestens einen Chip, der auf seiner dem Substrat zugewandten Oberfläche eine oder mehrere aktive Strukturen trägt, wobei das Substrat und der mindestens eine Chip über einen Versiegelungsrahmen so miteinander verbunden sind, dass die eine oder mehreren aktive(n) Struktur(en) gegenüber Umwelteinflüssen ausreichend geschützt ist/sind, wobei jeder Chip auf seiner dem Substrat zugewandten Oberfläche mindestens eine elektrische Kontaktstelle trägt, die mit einer oder der/den aktiven Struktur(en) in leitendem Kontakt steht, und dass die oder mindestens eine der genannten elektrischen Kontaktstellen eines jeden Chips mit einer auf dem Substrat befindlichen, elektrischen Kontaktstelle elektrisch leitend verbunden ist, die ihrerseits mit einer Leiterstruktur auf dem oder innerhalb des Substrats verbunden ist, welche sich auf dem Substrat außerhalb der von dem oder den Chips besetzten Arealen ankontaktieren lässt.

Dies hat den Vorteil, dass die elektrische Verbindung zwischen der/den aktiven Strukturen und dem Substrat ausschließlich über die genannten Kontaktstellen auf dem Substrat und dem/den Chip(s) erfolgen kann. (Dies ist jedoch nicht unabdingbar, denn ggf. könnte beispielsweise die elektrische Verbindung zusätzlich auch über den Versiegelungsrahmen bzw. über Teile davon laufen, wobei dieser nach außen hin isoliert sein könnte.) Auf diese Weise kann eine Bereitstellung von elektrischen Verbindungen durch den bzw. die Chips hindurch, die z.B. in Form von Vias oder anderen Durchführungen erzeugt werden müssten, und deren Ankontaktierung auf der (oben liegenden) Rückseite der Chips vermieden bzw. die Rückseite für andere Zwecke oder weitere Kontakte freigehalten werden.

Unter "Bauteil" sind nachstehend konstruktive Elemente zu verstehen, bei denen es sich in der Regel um Vorstadien der letztendlich zu erzeugenden Bauelemente handelt.

Die Erfindung wird beispielhaft anhand der Figuren 1 bis 7 erläutert, wobei
**Figur 1** das Substrat mit zwei Chips in bestücktem Zustand zeigt und die Justierung der Chips zum Substrat angedeutet ist,
**Figur 2** den Versiegelungs- und Kontaktierungsprozess illustriert,
**Figur 3** eine spezielle Ausgestaltung des Versiegelungsrahmens zeigt, der die passive Ausrichtung erleichtert und vor Verrutschen schützt,
**Figur 4** eine spezielle Ausgestaltung der Materialien und Geometrien von Versiegelungsrahmen und Kontaktstellen zeigt,
**Figur 5** eine weitere Ausgestaltung der Materialien und Geometrien von Versiegelungsrahmen und Kontaktstellen zeigt,
**Figur 6** schematisch die Bauteile für einen gasartspezifischen Sensor zeigt,
**Figur 7** schematisch die Bauteile für einen Sensor mit Medienzugang zeigt und
**Figur 8** eine Variante der Erfindung zeigt, bei der zusätzlich eine weitere aktive Struktur, z.B. ein Sensor, auf dem Substrat angeordnet ist.

Die mikrostrukturierten Bauteile der vorliegenden Erfindung können in geeigneten Fällen aus einem (Einzel-)Substrat, z.B. einem bereits vereinzelten ASIC oder einem solchen Waferfragment, und einem (einzigen) Chip zusammengesetzt sein. Die vorliegende Erfindung betrifft aber vor allem solche Bauteile, bei denen ein Substrat, beispielsweise ein Wafer mit 20-30 cm Durchmesser, mehrere oder sogar sehr viele Chips tragen kann. Diese können einzeln vorliegen oder in einen Chipwafer integriert sein. Solche Systeme werden nachstehend auch als Subsysteme bezeichnet. Sie können zur Herstellung der einzelnen Mikrobauelemente später in bekannter Weise vereinzelt werden, beispielsweise durch Wafersägen.

Als Substrat in der vorliegenden Erfindung eignet sich prinzipiell jedes Substrat, das für Mikrobauteile bzw. Subsysteme eingesetzt werden kann. Vorrangig ist ein Siliziumwafer oder ein anderes Halbleiterbauelement zu nennen; das Substrat kann jedoch auch eine Leiterplatte, ein Glasträger oder dergleichen sein. Die grundlegende Aufgabe des Substrats ist es, für die Weiterleitung der von der oder den aktiven Strukturen (Sensoren, Aktuatoren) empfangenen Signale eines jeden Chips mindestens eine Ankontaktierungsstelle für die Verschaltung des späteren Mikrobauelements mit den jeweils notwendigen äußeren Komponenten sicherzustellen, von der die entsprechenden elektrischen Daten abgegriffen werden können. Darüber hinaus kann das Substrat ggf. selbst auch geeignete Schaltkreise umfassen, z.B. eine elektronische Auswerteschaltung, umfassend Schaltkreise zur Ansteuerung des Sensorelements, zur Messung von deren Signalen und/oder zur Kommunikation mit externen elektrischen Schaltkreisen. Damit wird in vielen Fällen die Entflechtung einer großen Anzahl von Signalen erleichtert, indem eine elektronische Vorverarbeitung innerhalb des Subsystems erfolgt.

Als Substrat eignet sich auch ein beliebiges solches, auf das ein Chip oder eine Mehrzahl von Chips bzw. ein Chipwafer gesetzt werden soll, um eine elektrische Umverdrahtung und eine schützende Verkappung miteinander zu kombinieren (z.B. Anordnen von (bei Bedarf rotierbaren) Bildsensoren oder Spiegelelementen auf einem Chip zum Schutz vor Umgebungseinflüssen, und Kombinieren dieses Chips mit einem lichtdurchlässigen Substrat, evtl. mit einer technologiebedingt erforderlichen Umverteilung der Kontaktstellen auf eine größere Fläche, so dass der Strahlengang von einer äußeren Lichtquelle, z.B. einem Laser, zu dem Bildsensor oder dem Spiegel unbehindert ist).

Da das Substrat und der/die Chip(s) aufgrund des Versiegelungsrahmens und der elektrischen Kontaktstrukturen zwischen sich einen geeignet wählbaren Abstand zueinander haben, kann die zu den Chips weisende Oberfläche des Substrats im Wesentlichen eben sein, wodurch Kosten für sonst ggf. erforderliche Oberflächenstrukturierungen vermieden werden können. Auf dieser Oberfläche können die Leiterstrukturen oberflächlich aufgebracht sein; vorzugsweise sind sie aber vergraben.

Mit diesem Substrat ist ein oder sind mehrere Chips verbunden. Wenn z.B. das Substrat ein Siliziumwafer ist, können mehrere hundert Chips darauf angeordnet sein. Diese können gleich oder verschieden ausgebildet sein.

Jeder Chip bzw. jedes Chipelement eines Chipwafers weist entsprechend der Verwendung des zukünftigen Mikrobauteils eine oder mehrere aktive Strukturen auf. Der Ausdruck "aktive Struktur" soll im Sinne der vorliegenden Erfindung Strukturen umfassen, die Umwelteinflüsse wie Geschwindigkeiten, Beschleunigungen, Drehungen, Lichtstrahlung, Feuchtigkeit, Magnetfeld, Schallwellen, pH-Wert, Temperatur oder dergleichen erfassen und in elektrische Signale umsetzen können (hier nachstehend als Sensoren bezeichnet), die elektrische, elektromagnetische, mechanische oder thermische Energie aufnehmen, wandeln, speichern und/oder abgeben können (z.B. Batterien, Akkumulatoren) und/oder die Bewegungen ausführen können ("Aktuatoren"), aber nicht darauf beschränkt sein. So können beispielsweise für Airbags vorgesehene Bauelemente drei verschiedene Beschleunigungssensoren enthalten, die Beschleunigungen in den drei Raumrichtungen x,y,z detektieren können. Ein Chip kann unterschiedliche aktive Strukturen mit unterschiedlichen Aufgaben enthalten, beispielsweise verschiedene Sensoren und/oder Batterien, die für ihren Betrieb unterschiedliche Umgebungsbedingungen benötigen.

Die aktive(n) Struktur(en) können auf der Oberfläche des Chips bzw. des Chipwafers angebracht sein, weshalb es nicht notwendig ist, dafür Kavitäten in der Chipoberfläche vorzusehen. Diese kann daher im Wesentlichen eben ausgebildet sein. Selbstverständlich kann die Chipoberfläche aber auch Vertiefungen aufweisen, wenn dies notwendig oder wünschenswert sein sollte, beispielsweise für den Fall, dass die aktive(n) Struktur(en) relativ hoch sind und/oder weil die aktive(n) Struktur(en) aus der Chipoberfläche herausgeätzt wurden.

Ein Versiegelungsrahmen verbindet den bzw. die Chips mit dem Substrat. Dieser definiert den Abstand zwischen der Substrat- und der/den Chipoberflächen. Er wird deshalb so hoch gewählt, dass die aktiven Strukturen sicher und ohne anzustoßen gehäust werden können. Der Versiegelungsrahmen stellt die mechanische Verbindung zwischen Chip- und Waferoberfläche sicher. Er kann aus einem beliebigen Material bestehen, das die notwendige Steifigkeit besitzt, beispielsweise aus einem organischen Polymermaterial wie z.B. Polyimid oder Benzocyclobuten (BCB) oder einem anorganischen Material wie einem Metall oder einer Legierung oder Glas bzw. Glasfritte. Geeignet sind Metalle wie Au, Pd, AI oder Legierungen wie solche aus Cu/Sn oder Cu/Au. Der Rahmen kann aus einem einzigen Material bestehen oder durch Verbinden von unterschiedlichen, jeweils auf dem Substrat und dem Chipbestandteil aufgebrachten Metallen, die im Verbindungsbereich eine Legierung bilden, erzeugt werden. Er kann auf einem Untergrund aus Haftvermittler und/oder einem keimbildenden Metall aufgebracht sein.

Unter dem Ausdruck "Versiegelungsrahmen" ist nicht unbedingt zu verstehen, dass dieser vollständig durchgehend bzw. vollständig dichtend/hermetisch ist. So kann der Versiegelungsrahmen stattdessen auch durchbrochen sein, falls die aktiven Strukturen bei Umgebungsbedingungen arbeiten können/müssen. Er kann ggf. so unterteilt sein, dass er mehrere Räume umschließt, so dass verschiedene aktive Strukturen voneinander getrennt werden können. Dies kann z.B. notwendig sein, wenn deren Umgebung unterschiedliche Drücke/Gasmischungen aufweisen sollte. Werden diese Kavitäten bei einer definierten Gasatmosphäre durch das Verbinden von Substrat und Chip von der Umgebungsatmosphäre getrennt, kann der Gasdruck bzw. die Gasmischung in einem oder mehreren dieser Räumen z.B. später dadurch abgewandelt werden, dass darin ein Gettermaterial angebracht ist, das bei Aktivierung in definierbarer Weise Gasmoleküle aufnimmt und damit die Gasatmosphäre verändert. Gettermaterial kann auch dazu dienen, Feuchtigkeit zu absorbieren oder sogar Partikel einzufangen. Dieses Gettermaterial ist aus geometrischen Gründen vorzugsweise auf der Substratoberfläche vorgesehen.

Schließlich kann der Versiegelungsrahmen auch so ausgestaltet sein, dass er nur einen Teil der auf dem Chip vorhandenen aktiven Strukturen umschließt, während mindestens eine dieser aktiven Strukturen der Umgebungsatmosphäre oder dem Medium, in welchem das aktive Bauelement arbeiten soll, ausgesetzt bleibt. Dies kann beispielsweise dann günstig sein, wenn das zu erzeugende Mikrobauelement einen Feuchtigkeitssensor aufweisen soll. Alternativ kann der Versiegelungsrahmen durch Einbringung von Materialien mit hoher spezifischer Permeabilität so gestaltet sein, dass er für diese Struktur(en) eine begrenzte oder kontrollierte Gaszufuhr erlaubt. Beispielsweise kann er jeweils von außen nach innen durchgehende Schichten aus Palladium (durchlässig für Wasserstoff), SiO₂ (durchlässig für Helium) oder aus Kohlenstoff-Nanotubes aufweisen, wobei das letztere Material wasserdampfdurchlässig ist.

In einer spezifischen Ausgestaltung der Erfindung besitzt der Versiegelungsrahmen eine spezielle geometrische Gestalt, beispielsweise einen Fluidkanal. Hierfür kann er beispielsweise an den erforderlichen Stellen als Doppelkanal ausgebildet sein, in den Flüssigkeit durch zwei Substratlochungen ein- bzw. ausfließen kann.

Der Aufbau des Subsystems hat hinsichtlich der Signalführung folgende Vorteile: Leiterlängen können sehr kurz gehalten werden, so dass trotz geringem Flächeneinsatz gute oder sogar bessere (weil konstantere) elektrische Eigenschaften erzielt werden als in herkömmlichen Bauweisen. Ebenso erlaubt es die bevorzugte Kombination mit einer Halbleiterschaltung (in Fachkreisen als "System-in-Package" genannt), nur die in der Anwendungsschaltung benötigten Signale aus dem Messsystem herauszuführen und die Sensorversorgung und Signalübertragung intern zu führen, wodurch höhere Zuverlässigkeiten des Systems erreicht werden.

Die elektrische Kontaktierung zwischen Chip(s) und Substrat erfolgt über Kontaktstellen, die einander gegenüberliegen. Diese können als sogenannte "Bumps", erhabene Strukturen auf dem Substrat und dem Chip, die in elektrischem Kontakt miteinander stehen, realisiert sein. Die mechanische Verbindung zwischen Chip(s) und Substrat (also der Versiegelungsrahmen) kann ebenfalls aus leitendem Material gebildet sein. Die Materialien für den Versiegelungsrahmen und die Kontakte können die gleichen sein. In diesen Fällen kann, muss aber nicht, der Aufbau des Materials für die Versiegelungsringe und die Kontakte zusammen erfolgen, was Arbeitsschritte und Kosten spart.

Hierfür werden sowohl der/die Chip(s) als auch das Substrat in geeigneter Weise behandelt. Die Schritte können galvanisches oder stromloses Abscheiden von Metallen umfassen. Wird ein galvanisches Verfahren gewählt, können die Substrat- bzw. Wafer- und/oder Chipoberflächen in einem ersten Schritt mit einer durchgehenden Metallschicht (Potentiallage) versehen sein, z.B. optional mit Titan als Grundierung (wirkt als Haftvermittler) und einer darauf abgeschiedenen Schicht aus einem oder mehreren geeigneten Metallen wie Cr, Ti, Cr/Cu, Ti/Cu oder TiN. Diese Schicht wird in geeigneter Dicke, z.B. mit 3-50 nm, vorzugsweise ca. 5-20 nm und besonders bevorzugt ca. 10 nm, aufgebracht. Als oberste Schicht kann ggf. zusätzlich eine Goldschicht abgeschieden werden, die eine Dicke von bis zu ca. 200 nm, vorzugsweise bis ca. 100 nm besitzt.

Das Metall wird mit einem Photolack überschichtet, der anschließend unter Verwendung einer geeigneten Maske strukturiert wird. Die freigelegten Flächen werden sodann mit der eigentlichen Metallschicht versehen, die z.B. aus Gold, Kupfer, Nickel oder gegebenenfalls auch Palladium oder einer Kombination dieser Materialien bestehen kann. Die Goldlage kann ggf. noch mit einer Zinnschicht überlagert werden. Für diese Metallisierung(en) wird die Potentiallage unter Strom gesetzt. Man lässt die Metallschicht in einer ausreichenden Gesamtdicke (Dicke auf dem Substrat plus Dicke auf dem Chip) aufwachsen, damit die aktive(n) Struktur(en) auf den Chips nach dem Verbinden genügend Platz zwischen der Substrat- und der Chipoberfläche finden. Die Gesamtdicke kann beispielsweise ca. 0,5 µm bis 50 µm, vorzugsweise 2-20 µm betragen, abhängig von den Strukturen auf den Chips. Soll zusätzlich eine Sn-Schicht vorhanden sein, reicht ein Dickenanteil von ca. 1-3 µm für diese aus.

Anschließend werden zuerst der Lack (vorzugsweise mit Hilfe geeigneter Lösemittel) und sodann die Metallgrundierung (z.B. trocken, durch Argon-Beschuss, oder in einem Nassätzverfahren, das die sehr dünne Startmetallisierung wegätzt) abgetragen.

Gold, Nickel, Kupfer, ggf. Palladium oder die oben beschriebene Kombination hieraus wird vorzugsweise dann als oberste Schicht eingesetzt, wenn der Aufbau der Kontakte und des Versiegelungsrahmens nur auf einer Seite, der Chip- oder der Substratseite, erfolgen soll. Denn diese Metalle können beim späteren Verpressen mit der gegenüberliegenden Oberfläche reagieren. Wenn diese, was bevorzugt ist, aus Silizium besteht, bildet sich dabei nämlich eine innige Verbindung einer Metall-Silizium-Legierung aus, die relativ hoch schmilzt. In derartigen Ausgestaltungen können Si-Erhebungen oder Ringe auf der Chipoberfläche ausgebildet sein, die beispielsweise mit Hilfe von Ätzverfahren realisiert werden.

Alternativ wird auf beiden Seiten ein Aufbau mit einer Goldschicht realisiert. In diesem Fall kann auf einer oder beiden Seiten (Substrat- und/oder Chipseite) darauf noch die oben erwähnte dünne Zinnschicht aufgebracht werden. Werden Substrat und Chip verpresst, kann sich eine Au/Sn-Legierung zwischen den Teilen ausbilden, die höher schmilzt als die reinen Metalle. Diese Technik wird auch als reaktives Fügen ("Löten") bezeichnet.

Bei Bedarf werden der Versiegelungsring und die Kontaktstrukturen stattdessen aus unterschiedlichen Materialien und/oder vermittels unterschiedlicher Technik gefertigt. Sie können dabei jeweils aus Metall bestehen. Der Versiegelungsring kann stattdessen auch aus einem organischen Material bestehen, beispielsweise aus Polyimid oder Benzocyclobuten (BCB). Dieses Material wird auf einer oder auf beiden Seiten (Chip- und/oder Substratseite) in Form von Prepolymeren oder Monomeren flächig aufgebracht und über eine geeignete Maske belichtet. Nach Herauslösen des unbelichteten Materials erhält man den strukturierten Versiegelungsring.

Es kann günstig sein, ist aber nicht immer notwendig, dass der Versiegelungsring nur auf dem Substrat ausgebildet wird, weil die Chipoberflächen aktive Strukturen tragen, die bei dessen Herstellung geschützt werden müssten.

Statt der obigen Verfahren können natürlich beliebige andere Verfahren eingesetzt werden. So können Aluminiumstrukturen aufgesputtert oder aufgedampft werden. Insbesondere kann es günstig sein, die Kontakte in Form von Kugeln ("Bumps") aufzulöten oder anderweitig punktuell, ohne vorherige Flächenbeschichtung, aufzubringen.

Über diese Bumps lässt sich der Abstand zwischen der Substratoberfläche und der Sensoroberfläche sehr genau einstellen.

Die Bumps oder sonstigen erhabenen Kontaktstellen lassen sich vorteilhaft gleichermaßen als Strukturen für die Justierung zwischen dem Substrat und dem Chip/Chipwafer bzw. den einzelnen Chips einsetzen. Hierfür werden sie oder einige von ihnen geringfügig höher (z.B. ca. 0,5-5µm höher) als der Versiegelungrahmen aufgebaut. Die Verbindung des Substrats mit dem/den Chip(s) erfolgt in diesen Fällen vorzugsweise zweistufig. In der ersten Stufe werden die Teile relativ zueinander in die korrekte horizontale Lage verbracht und zur Speicherung dieser Lage vorfixiert. Hierfür sind 1 bis 3 Haltepunkte pro Chip ausreichend; günstig sind etwa bis zu 4 Haltepunkte. Der Versiegelungsrahmen darf in dieser Phase noch nicht abdichten, es ist wünschenswert, dass ein Spalt von ca. 1-2 µm verbleibt. Der Fixierungsprozess erfolgt vorzugsweise mit einem vorgewärmten Substrat (günstig sind 100-150°C) und einem mäßigen Anpressdruck (günstig sind häufig 20-35 gr. Anpressdruck pro Fixierungsstruktur des Chips). Vorteilhaft ist auch eine Ultraschalleinleitung in den Chip (lateral oder vertikal), wodurch sowohl die Kraft als auch die Vortemperierung und Prozesszeit reduziert werden können. Die Ultraschalleinleitung kann mit oder ohne Bauteiltemperierung durchgeführt werden, wobei darauf zu achten ist, dass die Temperatur der Teile unterhalb der Schmelztemperatur des jeweils am niedrigsten schmelzenden Metalls bleibt. Organische Fügehilfsmittel sollten bei dieser Verfahrensvariante in der Regel weggelassen werden.

In einer zweiten Stufe wird das vorfixierte Bauteil sodann in eine Kammer verbracht, in der eine gewünschte Gasatmosphäre mit dem Druck (bzw. Unterdruck/Vakuum) bereitgestellt wird, wie sie nach dem Verpressen in den Kavitäten der fertigen Bauteile herrschen soll. Dort wird das Substrat mit dem/den Chips unter Anwendung geeigneter Drücke, beispielsweise ca. 20-60 N/cm² verpresst, optional unter Erwärmen mindestens einer der Seiten (meist des Substrats) oder von beiden Seiten. Die Temperatur hierfür hängt von den eingesetzten Materialien ab und kann vom Fachmann unschwer ermittelt werden. Sie liegt bei der Versiegelung durch einen Doppelrahmen mit Gold oder Kupfer auf dessen Oberfläche in der Regel bei ca. 240-420°C, kann aber selbstverständlich in geeigneter Weise angepasst werden, wenn andere Materialien eingesetzt werden. Die Verpressung erfolgt derart, dass die gewünschte Dichtigkeit erzielt wird.

In einer besonders bevorzugten Ausgestaltung der Erfindung wird dementsprechend ein Verfahren zum Herstellen der vorgenannten mikrostrukturierten Bauteile bzw. Subsysteme zur Verfügung gestellt, das die folgenden Schritte umfasst:
- Bereitstellen mindestens eines Chips, der auf einer seiner Oberflächen eine oder mehrere aktive Strukturen und mindestens eine elektrische Kontaktstelle trägt, derart, dass diese Oberfläche nach unten zeigt und damit einem Substrat zugewandt ist, und
- Bereitstellen eines Substrats, das mindestens eine elektrische Kontaktstelle pro Chip trägt, die ihrerseits mit einer Leiterstruktur auf dem oder innerhalb des Substrats verbunden ist, welche sich auf dem Substrat außerhalb der von dem oder den Chips zu besetzenden Arealen ankontaktieren lässt,
   wobei eine der beiden genannten, auf dem Chip bzw. auf dem Substrat vorhandenen Kontaktstellen oder beide Kontaktstellen eine metallische Erhebung aufweist/aufweisen, und wobei entweder jeder Chip und/oder das Substrat auf jedem für einen Chip vorgesehenen Areal eine für einen geschlossenen Versiegelungsrahmen vorgesehene Erhebung aufweist,
- Justieren des mindestens einen Chips zum Substrat in korrekte Horizontalstellung dadurch, dass mindestens eine Kontaktstelle pro Chip gegenüber einer entsprechenden Kontaktstelle auf dem Substrat in ihrer Stellung fixiert wird,
- Ausüben von Druck und/oder Temperatur von oben auf den mindestens einen Chip und von unten auf das Substrat, derart dass sich das Material des Versiegelungsrahmens dichtend mit dem gegenüberliegenden Material verbindet.

Eine Vorfixierung erfolgt dabei in günstiger Weise dadurch, dass wie oben bereits erwähnt ein Teil der oder alle Erhebungen bzw. Bumps auf den jeweiligen Kontaktstellen von Chip und Substrat zusammen jeweils höher sind als die für den Versiegelungsrahmen vorgesehenen Erhebungen. Alternativ kann eine Vorfixierung auch durch das Aufbringen dickerer Lackpunkte außerhalb des Versiegelungsrahmens erfolgen.

Statt dessen oder zusätzlich ist es möglich, den Versiegelungsrahmen aus (z.B. zwei) Teilelementen auf Substrat und Chip auszubilden, die stufig gestaltet sind, derart, dass sie beim Verbinden ineinander greifen. Die Stufen können beispielsweise umlaufen, derart, dass das eine Teilelement ein höheres äußeres Ringsegment und das andere Teilelement ein höheres inneres Ringsegment aufweisen. Beim Zusammenfügen greifen dann die einander gegenüberliegenden Oberflächen ineinander, wodurch die passive Ausrichtung von Substrat und Chip zueinander verbessert und ein Verrutschen beim Zusammenfügen verhindert wird.

Weiterhin ist es möglich, den Versiegelungsrahmen dadurch aufzubauen, dass Teilelemente auf dem Substrat und dem/den Chips derart versetzt zueinander angeordnet werden, dass sie beim Verpressen der Teile in reibschlüssige Verbindung zueinander gelangen.

Werden der Versiegelungsrahmen und/oder die elektrischen Kontaktstellen beidseitig aus Gold aufgebaut, das eine dünne Zinnschicht trägt, wie weiter oben beschrieben, ist es bevorzugt, diese Zinnschicht, die ggf. nur einseitig aufgebracht sein kann, untermaßig (also schmäler, d.h. mit einer geringeren Querschnittsfläche) anzuordnen. Hierdurch können die notwendigen Fügekräfte reduziert werden, und es wird weniger Metallschmelze gebildet, wodurch weniger Ausfließprobleme der überschüssigen Schmelze auftreten. Auch mit den anderen genannten Materialien kann eine derartige Geometrie manchmal vorteilhaft sein.

Das erfindungsgemäße Verfahren zeichnet sich insbesondere dadurch aus, dass in ein und demselben Schritt die Kavität(en) zum Einschließen der aktiven Strukturen gebildet/bereitgestellt und die elektrische(n) und die mechanische(n) Verbindung(en) zwischen Substrat und Chip(s) geformt werden. Dabei kann je nach Bedarf die oder eine Kavität oder ein Teil vorhandener Kavitäten hermetisch oder sogar vakuumdicht versiegelt werden.

Die vorliegende Erfindung ist sowohl auf einfache als auch auf kompliziert aufgebaute Bauelemente anwendbar. Wenn in einem Chip beispielsweise mehrere Sensoren oder Aktuatoren untergebracht sind, kann der Versiegelungsrahmen so gestaltet sein, dass er alle oder nur denjenigen Teil der aktiven Strukturen gegenüber der Umgebung abdichtet, die die normalen Umweltbedingungen (Gaszusammensetzung, Druck, Feuchtigkeit) nicht vertragen, während solche Strukturen, die mit der Umgebung in Kontakt bleiben sollen, außerhalb des Versiegelungsrings liegen können, wie beispielsweise ein Feuchtigkeits- oder pH-Wert-Sensor. Darüber hinaus kann der Versiegelungsrahmen so gestaltet sein, dass er den Innenraum des späteren Bauelements dichtend unterteilt, so dass mehrere Kavitäten für verschiedene Sensoren oder andere aktive Strukturen bereitgestellt werden. Durch geeignete Maßnahmen lässt es sich erreichen, dass in diesen Kavitäten später ggf. unterschiedliche Bedingungen, z.B. unterschiedliche Gaszusammensetzungen und/oder Drücke herrschen, beispielsweise dadurch, dass in einer oder mehreren solcher getrennter Kammern Gettermaterial angebracht wird, das einen Teil des darin eingeschlossenen Gases im Verlauf der Zeit, ggf. nach geeigneter Aktivierung wie dem Fachmann bekannt, absorbiert.

Die Erfindung ist für alle kalibrierfähigen Sensoraufbauten geeignet, insbesondere für Inertialsensoren, Bildsensoren, Mikrofone, Drucksensoren und andere Sensoren, aber auch für direkt angesteuerte Aktuatoren (z.B. Spiegel), die ggf. mit geeigneten Energieträgern wie Batterien oder Akkumulatoren gekoppelt sein können.

In einer ganz besonders spezifischen Ausgestaltung der Erfindung enthalten die Bauteile Kavitäten, in denen mindestens zwei aktive Strukturen, insbesondere zwei Inertialsensoren, untergebracht sind. Um diese in räumlich günstiger Weise anzuordnen, kann erfindungsgemäß mindestens die zweite dieser Strukturen bodenseitig am Substrat angebracht sein. Diese kann im Substrat innerhalb einer Vertiefung vorgesehen (z.B. aus dem Material des Substrats herausgeätzt) sein; bei Ausbilden einer ausreichenden Dicke des Versiegelungsrahmens kann das Substrat statt dessen aber auch eine ebene oder weitgehend ebene Oberfläche besitzen.

Die mindestens zwei genannten Strukturen können beispielsweise zwei oder mehr Sensoren sein, die eine Beschleunigung oder eine Drehrate um zwei oder drei senkrecht aufeinander stehende Achsen des Raumes messen. Alternativ oder zusätzlich kann mindestens eine aktive Struktur ein Sensor sein, der eine Eigenschaft der Kavität misst, in der er (z.B. mit mindestens einem weiteren, vorzugsweise eine äußere Eigenschaft messenden) Sensor untergebracht ist. Beispiele für solche Sensoren sind Feuchtigkeitssensoren oder Drucksensoren zur Überprüfung der Gehäusedichtigkeit. Feuchtigkeitssensoren können beispielsweise in Form eines feuchteempfindlichen Dielektrikums vorliegen, z.B. in Form von unverdichtetem (nanoporösem) SiO₂. Eine Zunahme des Feuchtegehalts kann dabei durch die Änderung der Dielektrizitätskonstante dieses Materials festgestellt werden, die mit Hilfe von hochfrequenter Impedanzmessungen ermittelt werden kann. Eine Alternative ist das Vorsehen eines Mikroresonators aus nanoporösem (geätztem) Silizium. Hier erfolgt der Nachweise der Wassermoleküleinlagerung in die Poren des Schwingers durch Messung der Frequenzverschiebung.

Für die voranstehend genannte spezifische Ausführungsform der Erfindung können die gleichen Herstellungsverfahren angewendet werden wie oben angegeben, wobei es jedoch besonders günstig ist, nicht mit Einzelchips, sondern mit Chipwafern zu arbeiten. Hierbei werden sowohl das Substrat als auch der Chipwafer mit einer Mehr- oder Vielzahl von aktiven Strukturen, beispielsweise Sensoren, bestückt, und das Substrat und der Chipwafer werden über Versiegelungsrahmen miteinander verbunden. Hierbei wird eine hohe Integrationsdichte erzielt. Diese Variante der Erfindung ist insbesondere für Mehrachsen-Inertialsensorik für Navigations- und Sicherheitsanwendungen interessant.

Nachstehend soll die Erfindung anhand der Figuren beispielhaft näher erläutert werden.

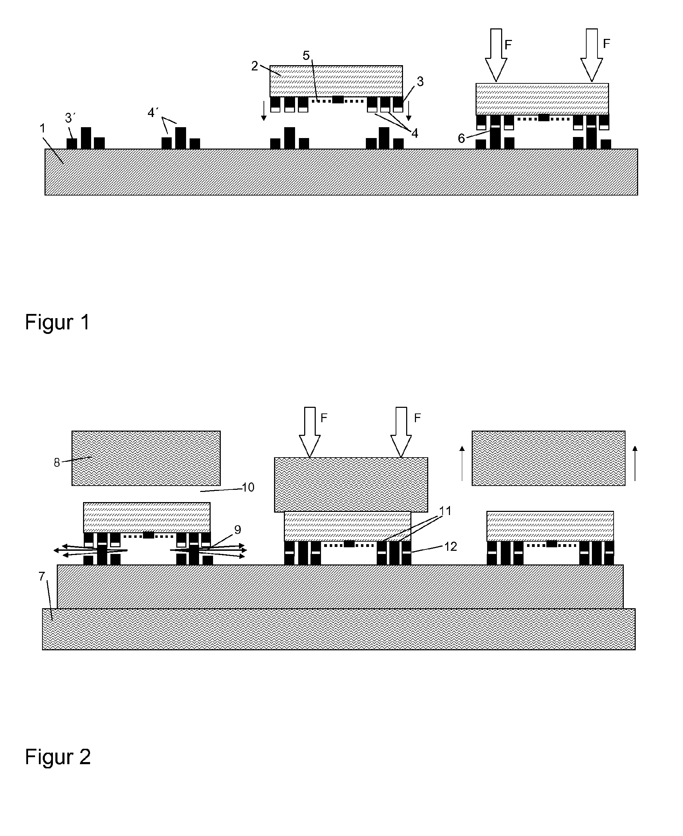

In **Figur 1** ist ein Substrat 1 gezeigt, bei dem es sich z.B. um einen Wafer mit (nicht gezeigten) integrierten Schaltungen handeln kann. Der Wafer ist an den entsprechenden Stellen mit einer Erhebung 3' für den späteren Versiegelungsrahmen und mit Kontaktbumps 4' bestückt, die unterschiedliche Höhen aufweisen (siehe auch Bezugsziffer 6). Bereits vereinzelte Chips 2 tragen entsprechende Erhebungen 3, 4, die später mit den Erhebungen 3', 4' bzw. zu elektrisch leitenden Verbindungen und dem Versiegelungsrahmen zusammengefügt werden. Bei der Vorfixierung mit einer auf den Chip aufgebrachten Kraft F dienen die überhöhten Kontakte 6 der Justierung der Spalthöhe. Mit 5 ist schematisch eine aktive Struktur, beispielsweise ein (beweglicher) Sensor angedeutet.

Der Versiegelungs- und Kontaktierungsprozess ist in **Figur 2** dargestellt. Eine bei Bedarf heizbare Platte 7 stützt das Substrat 1 ab, eine heizbare Druckplatte 8 wird in einen Abstand 10 über den bzw. die Chips gefahren. Die Abstände zwischen den Kontaktbumps bzw. den für den Versiegelungsrahmen vorgesehenen Teilen sind so gewählt, dass nach der Vorfixierung ein umlaufender Spalt 9 verblieben ist, durch den Gas aus der die aktive Struktur umgebende Kammer gezogen und/oder durch den gezielt eine vorgewählte Gasmischung eingebracht werden kann. Nachdem sichergestellt ist, dass der gewünschte Gasatmosphärenausgleich zwischen der Umgebung und der inneren Kammer erreicht ist, wird die Druckplatte 8 mit der Kraft F abgesenkt, wobei sich die elektrischen Anschlusskontakte 11 und der hermetische Versiegelungsrahmen 12 mit metallurgischer Fügezone ausbilden. Anschließend wird die Presse geöffnet.

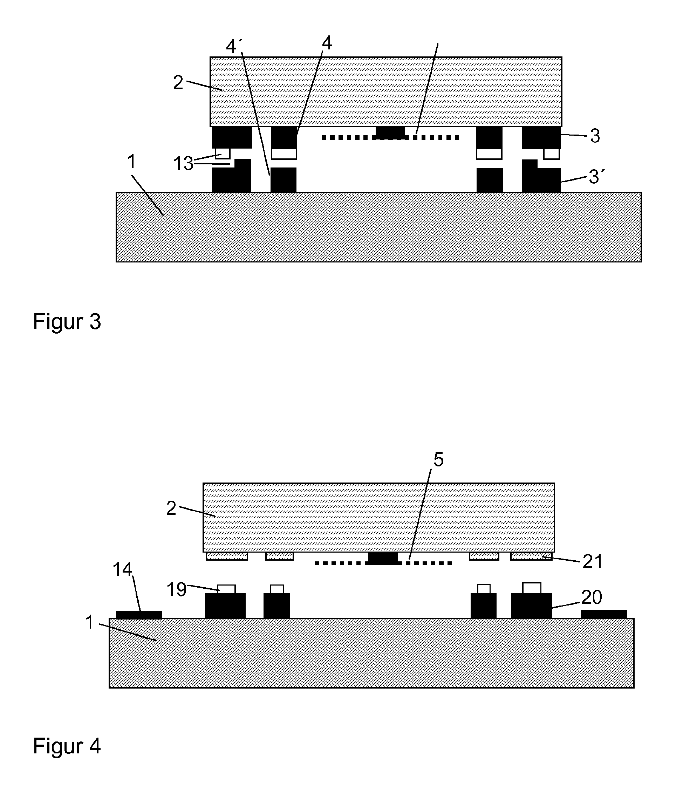

In **Figur 3** ist eine Variante eines Versiegelungsrahmens gezeigt, der aus zwei Teilen mit ineinandergreifender Ringstruktur 13 gebildet ist. Wie in der Beschreibung erläutert, dient diese Ausgestaltung der passiven Ausrichtung und dem Schutz gegen Verrutschen.

**Figur 4** visualisiert eine Ausgestaltung der Erfindung, in der sowohl die Kontaktbumps als auch der Versiegelungsrahmen dadurch gebildet werden, dass auf dem Substrat metallische Bumps und/oder eine metallische Rahmenerhöhung 20 aufgebracht werden, die beim nachfolgenden Fügen nicht aufschmelzen, aber überschüssiges Eutektikum aufnehmen können, das aus der Fügezone gepresst wird. Als Material hierfür eignet sich beispielsweise Kupfer. Auf die Kupfererhebungen ist Gold im Untermaß aufgebracht (mit Bezugsziffer 19 bezeichnet). Die chipseitigen Erhebungen 21 bestehen aus Silizium und sind in der Regel durch Ätzgräben definiert. Durch den verringerten Querschnitt der Goldauflagen wird die Menge der beim Fügen gebildeten Metallschmelze (AuSi-Eutektikum) reduziert. In dieser Figur ist ein Bondpad 14 gezeigt, das durch eine (nicht gezeigte) im Substrat verlaufende Leitungsstruktur mit den Kontakten verbunden ist. Über dieses Bondpad außerhalb der Gehäuses lässt sich die aktive Struktur ansteuern und lassen sich die von ihr erzeugten, gegebenenfalls bereits verarbeiteten Signale weiterleiten.

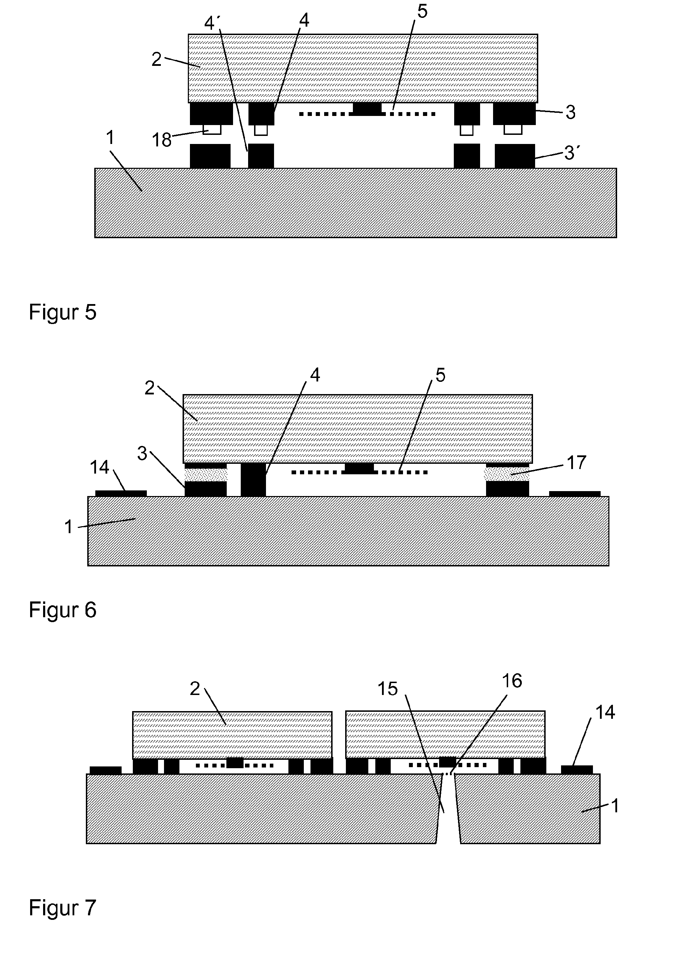

Eine Reduzierung der Metallschmelze lässt sich auch bei der in **Figur 5** gezeigten Ausführungsform erreichen. Hier wird auf die Golderhebungen eine dünne Zinnschicht im Untermaß aufgebracht (mit 18 bezeichnet). Beim Fügen bilden sich daher nur geringe Mengen an AuSn-Eutektikum.

Zwei spezifische Ausgestaltungen von Bauelementen zeigen die Figuren 6 und 7. Der in **Figur 6** angedeutete, gasartspezifische Sensor besitzt einen Versiegelungsrahmen, in den lateral durchgehend ein Material 17 mit erhöhter Durchlässigkeit für ein Gas eingebaut ist. Dieses Material kann beispielsweise Palladium, SiO₂ oder Kohlenstoff-Nanotubes sein und ist für ein spezifisches Gas wie Wasserstoff, Helium oder gasförmiges Wasser durchlässig. Damit lassen sich Bauelemente realisieren, die ungestört durch andere Umgebungsbedingungen die Konzentration solcher Gase messen können. Die in **Figur 7** gezeigte Variante zeigt ein Bauelement, das mit einer Substratlochung 15 versehen ist, die den Zutritt eines Umgebungsmediums in den Raum erlaubt, der eine von mehreren aktiven Strukturen umgibt. Die Lochung kann bei Bedarf mit einer (porösen) Membran oder einer Polymerschicht 16 abgedeckt sein, die z.B. Partikel oder andere unerwünschte Bestandteile der Umgebungsatmosphäre bzw. des Umgebungsfluids abhalten kann. Diese Variante zeigt ein Bauteil für ein späteres Bauelement, in welchem zwei aktive Strukturen auf zwei Chips separat auf einem Substrat gehäust sind.

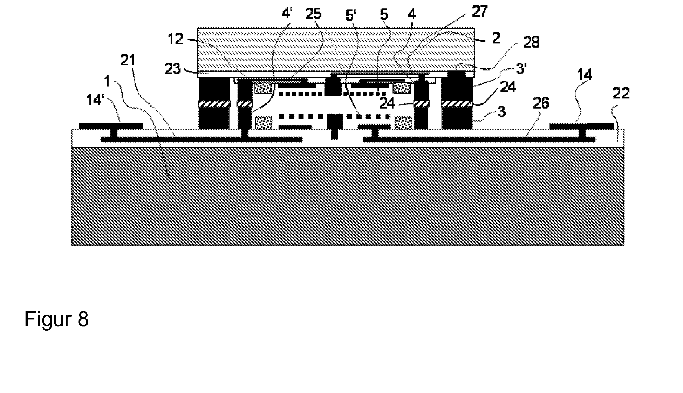

In **Figur 8** ist eine Variante der Erfindung schematisch dargestellt, die eine zweite aktive Struktur 5' auf der Oberfläche des Substrats 1 besitzt und bei der die elektrische Verbindung von der aktiven Struktur 5 im Deckel 2 zu einem Bondpad 14' außerhalb des Versiegelungsrahmens gezeigt ist. Der Chip 2 ist mit einer isolierenden Auflage 23 versehen, in die eine erste elektrische Verbindung 25 von einer ersten Elektrode des Sensors 5 zu einem ersten Kotaktbump 4 führt. Dieser steht über eine geeignete metallische Verbindung mit einem ihm gegenüberliegenden, auf dem Substrat angeordneten Kontaktbump 4' in elektrisch leitendem Kontakt (Vertikalkontakt), beispielsweise über einen Fügewerkstoff 24 wie eine AuSn-Legierung, wenn es sich bei den Kontaktbumps um solche aus Gold handelt, wie oben beschrieben. In einer isolierenden Auflage 22 des Substrats 1 ist ebenfalls eine elektrische Leitungsstruktur oder aber eine integrierte Schaltung 21 vergraben, die zu einem Bondpad 14' außerhalb des Sensorgehäuses führt. Der Kontaktbump 4' steht mit der elektrischen Leitungsstruktur 21 im Substrat in Verbindung, so dass eine Elektrode oder Elektrodengruppe des Chipsensors 5 elektrisch von außerhalb der Sensorkavität angesteuert und/oder abgegriffen werden kann, ggf. nach geeigneter Prozessierung der elektrischen Signal in der Schaltung im Substrat.

Die Gegenelektrode der aktiven Struktur 5 im Chip 2 wird in vergleichbarer Weise über eine weitere elektrische Verbindung 27 in der isolierenden Schicht 23 und die innerhalb des Versiegelungsrahmens liegenden, elektrisch miteinander verbundenen Kontaktstellen 4, 4' auf der Deckel- und der Substratseite elektrisch mit einem Bondpad (nicht gezeigt) verbunden. Auch die zweite aktive Struktur, die sich auf dem Substrat befindet und die hier wiederum beispielhaft in Gestalt eine Sensors 5' angedeutet ist, wird über weitere, in der Isolierschicht 22 des Substrats 1 vergrabene Leiterbahnen oder integriere Schaltungen an Bondpads außerhalb des Versiegelungsrahmens ankontaktiert, von denen nur die rechtsseitige Leiterbahn 26 und das Bondpad 14 gezeigt sind.

Der Versiegelungsrahmen, der rein mechanische Aufgaben übernehmen kann, ggf. aber ebenfalls für elektrische Verbindungen genutzt werden könnte, ist in dieser Variante als aus den gleichen Materialien (in Form einer Rahmenmetallisierung 3, 24, 3') aufgebaut gezeigt wie die Kontaktstruktur 4, 24, 4' zwischen Chip und Substrat. Eine mögliche oder notwendige Außensisolierung ist nicht dargestellt.

Gegebenenfalls kann die Kavität, in der die beiden (oder noch mehr) Sensoren eingeschlossen sind, ein Gettermaterial enthalten, beispielsweise ein strukturiertes Dünnschichtgetter 12 an von den Sensoren nicht abgedeckten und nicht benötigten Oberflächen von Chip und/oder Substrat.

Mit der Bezugsziffer 28 ist - nur auf der rechten Seite dieser Figur - eine Variante angedeutet: Auf Wunsch kann nämlich eine Ankontaktierungsstruktur 28 im Bereich des Versiegelungsrahmens bzw. im Bereich einer (nicht gezeigten) vertikalen Kontaktierung vorgesehen sein, die den Substratkristall des oberen Sensors auf Erdpotential (oder ein beliebiges kontrolliertes Potential) legt und damit elektrische Aufladungseffekte verhindern kann.

Die Erfindung betrifft dementsprechend unter anderem die folgenden Gegenstände und Verfahren:
A. Ein mikrostrukturiertes Bauteil für Mikrosensoren oder andere aktive Mikrobauelemente, umfassend:
   ein Substrat (1) sowie mindestens einen Chip (2), der auf seiner dem Substrat zugewandten Oberfläche eine oder mehrere aktive Strukturen (5) trägt, wobei
      - das Substrat und der mindestens eine Chip (2) über einen Versiegelungsrahmen (3;3,24,3') so miteinander verbunden sind, dass die eine oder mehreren aktive(n) Struktur(en) gegenüber unerwünschten Umwelteinflüssen ausreichend geschützt ist/sind,
      - der mindestens eine Chip (2) auf seiner dem Substrat zugewandten Oberfläche mindestens eine elektrische Kontaktstelle (4) trägt, die mit einer oder der/den aktiven Struktur(en) (5) in leitendem Kontakt steht,
      - die oder mindestens eine der genannten elektrischen Kontaktstellen (4) eines jeden der genannten Chips mit einer auf dem Substrat befindlichen, elektrischen Kontaktstelle (4') elektrisch leitend verbunden ist, die ihrerseits mit einer Leiterstruktur auf dem oder innerhalb des Substrats verbunden ist, welche sich auf dem Substrat außerhalb der von dem oder den Chip(s) besetzten Arealen ankontaktieren lässt.
B. Ein mikrostrukturiertes Bauteil nach Absatz A, wobei die elektrische Verbindung zwischen der/den aktiven Strukturen (5) und dem Substrat ausschließlich über die genannten Kontaktstellen (4, 4') erfolgt.
C. Ein mikrostrukturiertes Bauteil nach Absatz A oder B, dessen Substratoberfläche und/oder dessen Chipoberfläche(n) im Wesentlichen oder vollständig eben ist/sind.
D. Ein mikrostrukturiertes Bauteil nach einem der Absätze A bis C mit einem durchgehenden, hermetischen Versiegelungsrahmen.
E. Ein mikrostrukturiertes Bauteil nach einem der voranstehenden Absätze, worin der mindestens eine Chip mehr als eine aktive Struktur enthält und der Versiegelungsrahmen so ausgestaltet ist, dass mindestens zwei aktive Strukturen gasdicht voneinander getrennt sind.
F. Ein mikrostrukturiertes Bauteil nach einem der voranstehenden Absätze, der auf dem mindestens einen Chip mehr als eine aktive Struktur enthält, wobei der Versiegelungsrahmen so ausgestaltet ist, dass mindestens eine der aktiven Strukturen nicht von gewünschten Umwelteinflüssen abgeschirmt ist.
G. Ein mikrostrukturiertes Bauteil nach einem der voranstehenden Absätze, worin der Versiegelungsrahmen zumindest teilweise als Fluidkanal ausgestaltet ist.
H. Ein mikrostrukturiertes Bauteil nach einem der voranstehenden Absätze, worin der Versiegelungsrahmen aus einem organischen Polymermaterial oder aus einem oder verschiedenen Metall(en) oder aus Glas oder Glasfritte gebildet ist.
I. Ein mikrostrukturiertes Bauteil nach einem der voranstehenden Absätze, worin der bzw. die Versiegelungsrahmen (3, 24, 3') und die miteinander leitend verbundenen (24), ankontaktierbaren Erhebungen bzw. Kontaktstellen (4, 4') aus demselben Material/denselben Materialien bestehen.
K. Ein mikrostrukturiertes Bauteil nach einem Absätze A bis G, worin der Versiegelungsrahmen aus einem nichtleitenden Material gebildet ist und die Kontaktstellen 4, 4' mit der zwischenliegenden leitenden Verbindung aus einem Metall oder aus verschiedenen Metallen gebildet sind.
L. Ein mikrostrukturiertes Bauteil nach einem der voranstehenden Absätze, worin das Substrat eine elektronische Auswerteschaltung oder Teilauswerteschaltung für die vom Chip empfangenen Signale und/oder eine Ansteuerung und/oder eine Treiberschaltung für an den Chip abzugebende Signale besitzt.
M. Ein mikrostrukturiertes Bauteil nach einem der voranstehenden Absätze, worin die Leiterstrukturen des Substrats so ausgebildet sind, dass nur für eine äußere Anwendungsschaltung benötigte Signale aus den von den Chips besetzten Arealen herausgeführt werden, während sich alle ggf. für eine Sensorversorgung und/oder Signalübertragung erforderlichen Strukturen in oder auf dem Chip und/oder in oder auf dem Substrat befinden.
N. Ein mikrostrukturiertes Bauteil nach einem der voranstehenden Absätze, worin das Substrat ein ASIC oder ein Siliziumwafer ist.
O. Ein mikrostrukturiertes Bauteil nach einem der voranstehenden Absätze, worin der mindestens eine Chip Bestandteil eines Chipwafers ist.
P. Ein mikrostrukturiertes Bauteil nach einem der voranstehenden Absätze, bei dem es sich um eine Inertialmesseinheit oder einen Teil davon handelt oder das durch Zerteilen in mindestens eine Inertialmesseinheit oder einen Teil davon überführt werden kann.
Q. Ein mikrostrukturiertes Bauteil nach einem der Absätze A bis O, bei dem es sich um eine skalierfähige Messeinheit oder einen Teil davon handelt oder das durch Zerteilen in mindestens eine skalierfähige Messeinheit oder einen Teil davon überführt werden kann, wobei die Messeinheit eine aktive Struktur, vorzugsweise mindestens einen Bildsensor, ein Mikrofon, einen Drucksensor oder Spiegel oder einen sonstigen Aktuator oder eine Kombination der vorgenannten aktiven Strukturen aufweist.
R. Ein mikrostrukturiertes Bauteil nach Absatz P, umfassend einen, zwei oder drei verschiedene Beschleunigungssensoren, die ggf. Beschleunigungen von mindestens zwei der drei senkrecht aufeinander stehenden Raumrichtungen x, y, z detektieren können.
S. Ein mikrostrukturiertes Bauteil nach Absatz P oder R, umfassend einen, zwei oder drei Drehratensensoren, die ggf. Drehraten in mindestens zwei der drei senkrecht aufeinander stehenden Raumrichtungen x, y, z detektieren können.
T. Ein mikrostrukturiertes Bauteil nach einem der Absätze R oder S, dadurch gekennzeichnet, dass die Inertialmesseinheit zusätzlich mit mindestens einer Batterie oder mindestens einem Akkumulator verbunden ist.
U. Ein mikrostrukturiertes Bauteil nach einem der Absätze R bis T, worin die genannten Sensoren innerhalb des genannten Versiegelungsrahmens untergebracht sind, wobei dieser einen einzigen Innenraum oder mehrere, hermetisch gegeneinander abgeschlossene, mit unterschiedlichen Drücken beaufschlagte Innenräume umschließt.
V. Mikrostrukturiertes Bauteil nach Absatz U, worin mindestens einer der genannten Sensoren am Substrat (1) befestigt oder integral damit ausgebildet ist und ein zweiter der genannten Sensoren am Chip (2) befestigt oder integral damit ausgebildet ist.
   a. Ein Verfahren zum Herstellen eines mikrostrukturierten Bauteils nach einem der voranstehenden Absätze, umfassend die folgenden Schritte:
      - Bereitstellen mindestens eines Chips (2), der auf einer seiner Oberflächen eine oder mehrere aktive Strukturen (5) und mindestens eine elektrische Kontaktstelle (4) trägt, derart, dass diese Oberfläche nach unten zeigt und damit einem Substrat zugewandt ist, und
      - Bereitstellen eines Substrats (1), das mindestens eine elektrische Kontaktstelle (4') pro genanntem Chip trägt, die ihrerseits mit einer Leiterstruktur auf dem oder innerhalb des Substrats verbunden ist, welche sich auf dem Substrat außerhalb (14) der von dem oder den Chips zu besetzenden Arealen ankontaktieren lässt, wobei eine der beiden Kontaktstellen (4) bzw. (4') oder beide Kontaktstellen (4,4') eine metallische Erhebung aufweist/aufweisen, und wobei entweder jeder der genannten Chips und/oder das Substrat auf jedem für einen der genannten Chips vorgesehenen Areal eine für einen Versiegelungsrahmen (3) vorgesehene Erhebung aufweist,
      - Justieren des mindestens einen Chips (2) zum Substrat (1) in korrekte Horizontalstellung dadurch, dass mindestens eine Kontaktstelle (4) pro Chip gegenüber einer entsprechenden Kontaktstelle (4') auf dem Substrat in ihrer Stellung fixiert wird,
      - Ausüben von Druck und/oder Temperatur von oben auf den mindestens einen Chip und/oder von unten auf das Substrat, derart dass sich das Material des Versiegelungsrahmens so mit dem gegenüberliegenden Material verbindet, dass die eine oder mehreren aktive(n) Struktur(en) gegenüber Umwelteinflüssen ausreichend geschützt ist/sind.
   b. Ein Verfahren nach Absatz a., worin das Substrat (1) auf seiner dem Chip (2) zugewandten Oberfläche eine oder mehrere aktive Struktur(en) (5) trägt.
   c. Ein Verfahren nach Absatz a. oder b., dadurch gekennzeichnet, dass der mindestens eine Chip (2) und das Substrat (1) beim Schritt des Justierens über die Kontaktstellen (4, 4'), ggf. mit Hilfe von vertikal ausgeübtem Druck und/oder erhöhter Temperatur, in ihrer Stellung zueinander vorfixiert werden.
   d. Ein Verfahren nach einem der Absätze a. bis c., worin das Verbinden unter Aufbringen von Wärme auf das Substrat oder den mindestens einen Chip oder auf das Substrat und den mindestens einen Chip erfolgt.
   e. Ein Verfahren nach einem der Absätze a. bis d., wobei entweder auf dem mindestens einen Chip und/oder auf dem Substrat mindestens eine metallische Erhebung der Kontaktstelle höher ist als die für den Versiegelungsrahmen vorgesehene Erhebung, derart, dass die Erhebung(en) auf den Kontaktstellen (4) und (4') von Chip(s) und Substrat zusammen höher sind (6) als die für den Versiegelungsrahmen vorgesehene(n) Erhebung(en) (3, 3'), so dass beim Justieren des mindestens einen Chips (2) zum Substrat (1) die Kontaktstellen (4 und 4') in Berührung kommen, bevor die für den Versiegelungsrahmen vorgesehene(n) Erhebung(en) (3 und 3') mit dem gegenüberliegenden Material in Berührung kommen.
   f. Ein Verfahren nach Absatz e., dadurch gekennzeichnet, dass der bzw. die Chip(s) und das Substrat jeweils eine Mehrzahl von Kontaktstellen (4, 4') aufweisen, wobei ein Teil der Kontaktstellen auf dem/den Chip(s) und/oder auf dem Substrat höher ist (6) als ein anderer Teil der Kontaktstellen auf diesem Chip bzw. diesem Substrat.
   g. Ein Verfahren nach einem der Absätze a. bis f., worin sowohl jeder der genannten Chips als auch das Substrat für den Versiegelungsrahmen vorgesehene Erhebungen aufweisen, die jeweils stufig ausgebildet sind, derart, dass die Erhebung(en) (3) auf einem jeden Chip und die Erhebung(en) (3') auf dem Substrat beim Fügen unter Ausbilden des Versiegelungsrahmens ineinandergreifen, und/oder worin die genannten Erhebungen auf dem/den Chips und auf dem Substrat versetzt zueinander angeordnet sind, derart, dass sie beim Ausüben von Druck zum Verbinden des Versiegelungsrahmens mit dem gegenüberliegenden Material reibschlüssig zueinander in Verbindung geraten.
   h. Ein Verfahren nach Absatz g., wobei die Stufen umlaufen, derart, das die Erhebung(en) auf dem/den Chip(s) ein höheres äußeres Rahmensegment aufweisen und die Erhebungen auf dem Substrat ein höheres inneres Rahmensegment aufweisen, oder vice versa.
   i. Ein Verfahren nach einem der Absätze a. bis h., worin alle oder ein Teil der Erhebungen aus Gold besteht/bestehen, auf das eine Zinnschicht aufgebracht ist.
   k. Ein Verfahren nach Absatz i., wobei die Zinnauflage eine kleinere Querschnittsfläche als der Querschnitt der Golderhebungen besitzt.
   l. Ein Verfahren nach einem der Absätze a. bis k., dadurch gekennzeichnet, dass im Schritt des Vorfixierens und/oder im Schritt des Fügens Ultraschall in das Substrat und/oder den mindestens einen Chip eingeleitet wird.
   m. Ein Verfahren nach einem der Absätze a. bis I., worin der Versiegelungsrahmen ein geschlossener Versiegelungsrahmen ist.
   n. Ein Verfahren nach einem der Absätze a. bis m., worin der Versiegelungsrahmen so gestaltet ist, dass er zwei oder mehrere, hermetisch gegeneinander abgeschlossene, mit unterschiedlichen Drücken beaufschlagte Innenräume umschließt.

Außerdem ist die Erfindung unter anderem auf die folgenden Verfahren und Gegenstände gerichtet:
I. Ein mikrostrukturiertes Bauteil für Mikrosensoren oder andere aktive Mikrobauelemente, umfassend:
   ein Substrat (1) sowie mindestens einen Chip (2), die auf ihren einander zugewandten Oberflächen jeweils eine oder mehrere aktive Strukturen (5) tragen,
      wobei
   - das Substrat und der mindestens eine Chip (2) über einen Versiegelungsrahmen (3; 3,24,3') so miteinander verbunden sind, dass jeweils mindestens eine aktive Struktur auf dem Chip und auf dem Substrat gegenüber unerwünschten Umwelteinflüssen ausreichend geschützt ist/sind,
   - der mindestens eine Chip (2) auf seiner dem Substrat zugewandten Oberfläche mindestens eine elektrische Kontaktstelle (4) trägt, die mit einer oder der/den aktiven Struktur(en) (5) in leitendem Kontakt steht,
   - die oder mindestens eine der genannten elektrischen Kontaktstellen (4) eines jeden der genannten Chips mit einer auf dem Substrat befindlichen, elektrischen Kontaktstelle (4') elektrisch leitend verbunden ist, die ihrerseits mit einer Leiterstruktur auf dem oder innerhalb des Substrats verbunden ist, welche sich auf dem Substrat außerhalb der von dem oder den Chip(s) besetzten Arealen ankontaktieren lässt.
II. Ein mikrostrukturiertes Bauteil nach Absatz I, wobei die elektrische Verbindung zwischen der/den aktiven Strukturen (5) und dem Substrat ausschließlich über die genannten Kontaktstellen (4, 4') erfolgt.
III. Ein mikrostrukturiertes Bauteil nach Absatz I oder 11, dessen Substratoberfläche und/oder dessen Chipoberfläche(n) im Wesentlichen oder vollständig eben ist/sind.
IV. Ein mikrostrukturiertes Bauteil nach einem der Absätze I bis III mit einem durchgehenden, hermetischen Versiegelungsrahmen.
V. Ein mikrostrukturiertes Bauteil nach einem der voranstehenden Absätze, worin der mindestens eine Chip mehr als eine aktive Struktur trägt und der Versiegelungsrahmen so ausgestaltet ist, dass mindestens zwei aktive Strukturen gasdicht voneinander getrennt sind.
VI. Ein mikrostrukturiertes Bauteil nach einem der voranstehenden Absätze, der auf dem mindestens einen Chip mehr als eine aktive Struktur trägt, wobei der Versiegelungsrahmen so ausgestaltet ist, dass mindestens eine der aktiven Strukturen nicht von gewünschten Umwelteinflüssen abgeschirmt ist.
VII. Ein mikrostrukturiertes Bauteil nach einem der voranstehenden Absätze, worin der Versiegelungsrahmen zumindest teilweise als Fluidkanal ausgestaltet ist.
VIII. Ein mikrostrukturiertes Bauteil nach einem der voranstehenden Absätze, worin der Versiegelungsrahmen aus einem organischen Polymermaterial oder aus einem oder verschiedenen Metall(en) oder aus Glas oder Glasfritte gebildet ist.
IX. Ein mikrostrukturiertes Bauteil nach einem der voranstehenden Absätze, worin der bzw. die Versiegelungsrahmen (3, 24, 3') und die miteinander leitend verbundenen (24), ankontaktierbaren Erhebungen bzw. Kontaktstellen (4, 4') aus demselben Material/denselben Materialien bestehen.
X. Ein mikrostrukturiertes Bauteil nach einem Absätze I bis VII, worin der Versiegelungsrahmen aus einem nichtleitenden Material gebildet ist und die Kontaktstellen 4, 4' mit der zwischenliegenden leitenden Verbindung aus einem Metall oder aus verschiedenen Metallen gebildet sind.
XI. Ein mikrostrukturiertes Bauteil nach einem der voranstehenden Absätze, worin das Substrat eine elektronische Auswerteschaltung oder Teilauswerteschaltung für die vom Chip empfangenen Signale und/oder eine Ansteuerung und/oder eine Treiberschaltung für an den Chip abzugebende Signale besitzt.
XII. Ein mikrostrukturiertes Bauteil nach einem der voranstehenden Absätze, worin die Leiterstrukturen des Substrats so ausgebildet sind, dass nur für eine äußere Anwendungsschaltung benötigte Signale aus den von den Chips besetzten Arealen herausgeführt werden, während sich alle ggf. für eine Sensorversorgung und/oder Signalübertragung erforderlichen Strukturen in oder auf dem Chip und/oder in oder auf dem Substrat befinden.
XIII. Ein mikrostrukturiertes Bauteil nach einem der voranstehenden Absätze, worin das Substrat ein ASIC oder ein Siliziumwafer ist.
XIV. Ein mikrostrukturiertes Bauteil nach einem der voranstehenden Absätze, worin der mindestens eine Chip Bestandteil eines Chipwafers ist.
XV. Ein mikrostrukturiertes Bauteil nach einem der voranstehenden Absätze, bei dem es sich um eine Inertialmesseinheit oder einen Teil davon handelt oder das durch Zerteilen in mindestens eine Inertialmesseinheit oder einen Teil davon überführt werden kann.
XVI. Ein mikrostrukturiertes Bauteil nach einem Absätze I bis XIV, bei dem es sich um eine skalierfähige Messeinheit oder einen Teil davon handelt oder das durch Zerteilen in mindestens eine skalierfähige Messeinheit oder einen Teil davon überführt werden kann, wobei die Messeinheit eine aktive Struktur, vorzugsweise mindestens einen Bildsensor, ein Mikrofon, einen Drucksensor oder Spiegel oder einen sonstigen Aktuator oder eine Kombination der vorgenannten aktiven Strukturen aufweist.
XVII. Ein mikrostrukturiertes Bauteil nach Absatz XV, umfassend einen, zwei oder drei verschiedene Beschleunigungssensoren, die ggf. Beschleunigungen von mindestens zwei der drei senkrecht aufeinander stehenden Raumrichtungen x, y, z detektieren können.
XVIII. Ein mikrostrukturiertes Bauteil nach Absatz XV oder XVII, umfassend einen, zwei oder drei Drehratensensoren, die ggf. Drehraten in mindestens zwei der drei senkrecht aufeinander stehenden Raumrichtungen x, y, z detektieren können.
XIX. Ein mikrostrukturiertes Bauteil nach einem der Absätze XVII oder XVIII, dadurch gekennzeichnet, dass die Inertialmesseinheit zusätzlich mit mindestens einer Batterie oder mindestens einem Akkumulator verbunden ist.
XX. Ein mikrostrukturiertes Bauteil nach einem der Absätze XVII bis XIX, worin die genannten Sensoren innerhalb des genannten Versiegelungsrahmens untergebracht sind, wobei dieser einen einzigen Innenraum oder mehrere, hermetisch gegeneinander abgeschlossene, mit unterschiedlichen Drücken beaufschlagte Innenräume umschließt.
XXI. Ein Verfahren zum Herstellen eines mikrostrukturierten Bauteils nach einem der voranstehenden Absätze, umfassend die folgenden Schritte:
   - Bereitstellen mindestens eines Chips (2), der auf einer seiner Oberflächen eine oder mehrere aktive Strukturen (5) und mindestens eine elektrische Kontaktstelle (4) trägt, derart, dass diese Oberfläche nach unten zeigt und damit einem Substrat zugewandt ist, und
   - Bereitstellen eines Substrats (1), das auf seiner Oberseite mindestens eine aktive Struktur und mindestens eine elektrische Kontaktstelle (4') pro genanntem Chip trägt, wobei die genannte Kontaktstelle (4') ihrerseits mit einer Leiterstruktur auf dem oder innerhalb des Substrats verbunden ist, welche sich auf dem Substrat außerhalb (14) der von dem oder den Chips zu besetzenden Arealen ankontaktieren lässt,
      wobei eine der beiden Kontaktstellen (4) bzw. (4') oder beide Kontaktstellen (4,4') eine metallische Erhebung aufweist/aufweisen, und wobei entweder jeder der genannten Chips und/oder das Substrat auf jedem für einen der genannten Chips vorgesehenen Areal eine für einen Versiegelungsrahmen (3) vorgesehene Erhebung aufweist,
   - Justieren des mindestens einen Chips (2) zum Substrat (1) in korrekte Horizontalstellung dadurch, dass mindestens eine Kontaktstelle (4) pro Chip gegenüber einer entsprechenden Kontaktstelle (4') auf dem Substrat in ihrer Stellung fixiert wird,
   - Ausüben von Druck und/oder Temperatur von oben auf den mindestens einen Chip und/oder von unten auf das Substrat, derart dass sich das Material des Versiegelungsrahmens so mit dem gegenüberliegenden Material verbindet, dass die eine oder mehreren aktive(n) Struktur(en) gegenüber Umwelteinflüssen ausreichend geschützt ist/sind.
XXII. Ein Verfahren nach Absatz XXI, dadurch gekennzeichnet, dass der mindestens eine Chip (2) und das Substrat (1) beim Schritt des Justierens über die Kontaktstellen (4, 4'), ggf. mit Hilfe von vertikal ausgeübtem Druck und/oder erhöhter Temperatur, in ihrer Stellung zueinander vorfixiert werden.
XXIII. Ein Verfahren nach einem der Absätze XXI oder XXII, worin das Verbinden unter Aufbringen von Wärme auf das Substrat oder den mindestens einen Chip oder auf das Substrat und den mindestens einen Chip erfolgt.
XXIV. Ein Verfahren nach einem der Absätze XXI bis XXIII, wobei entweder auf dem mindestens einen Chip und/oder auf dem Substrat mindestens eine metallische Erhebung der Kontaktstelle höher ist als die für den Versiegelungsrahmen vorgesehene Erhebung, derart, dass die Erhebung(en) auf den Kontaktstellen (4) und (4') von Chip(s) und Substrat zusammen höher sind (6) als die für den Versiegelungsrahmen vorgesehene(n) Erhebung(en) (3, 3'), so dass beim Justieren des mindestens einen Chips (2) zum Substrat (1) die Kontaktstellen (4 und 4') in Berührung kommen, bevor die für den Versiegelungsrahmen vorgesehene(n) Erhebung(en) (3 und 3') mit dem gegenüberliegenden Material in Berührung kommen.
XXV. Ein Verfahren nach Absatz XXIV, dadurch gekennzeichnet, dass der bzw. die Chip(s) und das Substrat jeweils eine Mehrzahl von Kontaktstellen (4, 4') aufweisen, wobei ein Teil der Kontaktstellen auf dem/den Chip(s) und/oder auf dem Substrat höher ist (6) als ein anderer Teil der Kontaktstellen auf diesem Chip bzw. diesem Substrat.
XXVI. Ein Verfahren nach einem der Absätze XXI bis XXV, worin sowohl jeder der genannten Chips als auch das Substrat für den Versiegelungsrahmen vorgesehene Erhebungen aufweisen, die jeweils stufig ausgebildet sind, derart, dass die Erhebung(en) (3) auf einem jeden Chip und die Erhebung(en) (3') auf dem Substrat beim Fügen unter Ausbilden des Versiegelungsrahmens ineinandergreifen, und/oder worin die genannten Erhebungen auf dem/den Chips und auf dem Substrat versetzt zueinander angeordnet sind, derart, dass sie beim Ausüben von Druck zum Verbinden des Versiegelungsrahmens mit dem gegenüberliegenden Material reibschlüssig zueinander in Verbindung geraten.
XXVII. Ein Verfahren nach Absatz XXVI, wobei die Stufen umlaufen, derart, das die Erhebung(en) auf dem/den Chip(s) ein höheres äußeres Rahmensegment aufweisen und die Erhebungen auf dem Substrat ein höheres inneres Rahmensegment aufweisen, oder vice versa.
XXVIII. Ein Verfahren nach einem der Absätze XXI bis XXVII, worin alle oder ein Teil der Erhebungen aus Gold besteht/bestehen, auf das eine Zinnschicht aufgebracht ist.
XXIX. Ein Verfahren nach Absatz XXVIII, wobei die Zinnauflage eine kleinere Querschnittsfläche als der Querschnitt der Golderhebungen besitzt.
XXX. Ein Verfahren nach einem der Absätze XXI bis XXIX, dadurch gekennzeichnet, dass im Schritt des Vorfixierens und/oder im Schritt des Fügens Ultraschall in das Substrat und/oder den mindestens einen Chip eingeleitet wird.
XXXI. Ein Verfahren nach einem der Absätze XXI bis XXX, worin der Versiegelungsrahmen ein geschlossener Versiegelungsrahmen ist.
XXXII. Ein Verfahren nach einem der Absätze XXI bis XXXI, worin der Versiegelungsrahmen so gestaltet ist, dass er zwei oder mehrere, hermetisch gegeneinander abgeschlossene, mit unterschiedlichen Drücken beaufschlagte Innenräume umschließt.

## Patentansprüche

1. Mikrostrukturiertes Bauteil für Mikrosensoren oder andere aktive Mikrobauelemente, umfassend:
ein Substrat (1) sowie mindestens einen Chip (2), die auf ihren einander zugewandten Oberflächen jeweils eine oder mehrere aktive Strukturen (5) tragen,
wobei
- das Substrat und der mindestens eine Chip (2) über einen Versiegelungsrahmen (3;3,24,3') so miteinander verbunden sind, dass die jeweils mindestens eine aktive Struktur auf dem Chip und auf dem Substrat gegenüber unerwünschten Umwelteinflüssen ausreichend geschützt ist/sind,
- der mindestens eine Chip (2) auf seiner dem Substrat zugewandten Oberfläche mindestens eine elektrische Kontaktstelle (4) trägt, die mit einer oder der/den aktiven Struktur(en) (5) in leitendem Kontakt steht,
- die oder mindestens eine der genannten elektrischen Kontaktstellen (4) eines jeden der genannten Chips mit einer auf dem Substrat befindlichen, elektrischen Kontaktstelle (4') elektrisch leitend verbunden ist, die ihrerseits mit einer Leiterstruktur auf dem oder innerhalb des Substrats verbunden ist, welche sich auf dem Substrat außerhalb der von dem oder den Chip(s) besetzten Arealen ankontaktieren lässt.

2. Mikrostrukturiertes Bauteil nach Anspruch 1, worin das Substrat eine elektronische Auswerteschaltung oder Teilauswerteschaltung für die vom Chip empfangenen Signale und/oder eine Ansteuerung und/oder eine Treiberschaltung für an den Chip abzugebende Signale besitzt.

3. Mikrostrukturiertes Bauteil nach einem der voranstehenden Ansprüche, worin die Leiterstrukturen des Substrats so ausgebildet sind, dass nur für eine äußere Anwendungsschaltung benötigte Signale aus den von den Chips besetzten Arealen herausgeführt werden, während sich alle ggf. für eine Sensorversorgung und/oder Signalübertragung erforderlichen Strukturen in oder auf dem Chip und/oder in oder auf dem Substrat befinden.

4. Mikrostrukturiertes Bauteil nach einem der voranstehenden Ansprüche, worin das Substrat ein ASIC oder ein Siliziumwafer ist.

5. Mikrostrukturiertes Bauteil nach einem der voranstehenden Ansprüche, worin der mindestens eine Chip Bestandteil eines Chipwafers ist.

6. Mikrostrukturiertes Bauteil nach einem der voranstehenden Ansprüche, bei dem es sich um eine Inertialmesseinheit oder einen Teil davon handelt oder das durch Zerteilen in mindestens eine Inertialmesseinheit oder einen Teil davon überführt werden kann.

7. Mikrostrukturiertes Bauteil nach Anspruch 6, umfassend einen, zwei oder drei verschiedene Beschleunigungssensoren, die ggf. Beschleunigungen von mindestens zwei der drei senkrecht aufeinander stehenden Raumrichtungen x, y, z detektieren können.

8. Mikrostrukturiertes Bauteil nach Anspruch 6 oder 7, umfassend einen, zwei oder drei Drehratensensoren, die ggf. Drehraten in mindestens zwei der drei senkrecht aufeinander stehenden Raumrichtungen x, y, z detektieren können.

9. Mikrostrukturiertes Bauteil nach einem der Ansprüche 7 oder 8, **dadurch gekennzeichnet, dass** die Inertialmesseinheit zusätzlich mit mindestens einer Batterie oder mindestens einem Akkumulator verbunden ist.

10. Mikrostrukturiertes Bauteil nach einem der Ansprüche 7 bis 9, worin die genannten Sensoren innerhalb des genannten Versiegelungsrahmens untergebracht sind, wobei dieser einen einzigen Innenraum oder mehrere, hermetisch gegeneinander abgeschlossene, mit unterschiedlichen Drücken beaufschlagte Innenräume umschließt.

11. Verfahren zum Herstellen eines mikrostrukturierten Bauteils nach einem der voranstehenden Ansprüche, umfassend die folgenden Schritte:
- Bereitstellen mindestens eines Chips (2), der auf einer seiner Oberflächen eine oder mehrere aktive Strukturen (5) und mindestens eine elektrische Kontaktstelle (4) trägt, derart, dass diese Oberfläche nach unten zeigt und damit einem Substrat zugewandt ist, und
- Bereitstellen eines Substrats (1), das auf seiner Oberseite mindestens eine aktive Struktur und mindestens eine elektrische Kontaktstelle (4') pro genanntem Chip trägt, wobei die genannte Kontaktstelle (4') ihrerseits mit einer Leiterstruktur auf dem oder innerhalb des Substrats verbunden ist, welche sich auf dem Substrat außerhalb (14) der von dem oder den Chips zu besetzenden Arealen ankontaktieren lässt,
wobei eine der beiden Kontaktstellen (4) bzw. (4') oder beide Kontaktstellen (4,4') eine metallische Erhebung aufweist/aufweisen, und wobei entweder jeder der genannten Chips und/oder das Substrat auf jedem für einen der genannten Chips vorgesehenen Areal eine für einen Versiegelungsrahmen (3) vorgesehene Erhebung aufweist,
- Justieren des mindestens einen Chips (2) zum Substrat (1) in korrekte Horizontalstellung dadurch, dass mindestens eine Kontaktstelle (4) pro Chip gegenüber einer entsprechenden Kontaktstelle (4') auf dem Substrat in ihrer Stellung fixiert wird,
- Ausüben von Druck und/oder Temperatur von oben auf den mindestens einen Chip und/oder von unten auf das Substrat, derart dass sich das Material des Versiegelungsrahmens so mit dem gegenüberliegenden Material verbindet, dass die eine oder mehreren aktive(n) Struktur(en) gegenüber Umwelteinflüssen ausreichend geschützt ist/sind.

12. Verfahren nach Anspruch 11, **dadurch gekennzeichnet, dass** der mindestens eine Chip (2) und das Substrat (1) beim Schritt des Justierens über die Kontaktstellen (4, 4'), ggf. mit Hilfe von vertikal ausgeübtem Druck und/oder erhöhter Temperatur, in ihrer Stellung zueinander vorfixiert werden.

13. Ein Verfahren nach einem der Ansprüche 11 oder 12, worin das Verbinden unter Aufbringen von Wärme auf das Substrat oder den mindestens einen Chip oder auf das Substrat und den mindestens einen Chip erfolgt.

14. Verfahren nach einem der Ansprüche 12 oder 13, **dadurch gekennzeichnet, dass** im Schritt des Vorfixierens und/oder im Schritt des Fügens Ultraschall in das Substrat und/oder den mindestens einen Chip eingeleitet wird.

15. Verfahren nach einem der Ansprüche 12 bis 14, worin der Versiegelungsrahmen so gestaltet ist, dass er zwei oder mehrere, hermetisch gegeneinander abgeschlossene, mit unterschiedlichen Drücken beaufschlagte Innenräume umschließt.
